Europäisches Patentamt

European Patent Office

Office européen des brevets

(11) Publication number: **0 434 051 A2**

## EUROPEAN PATENT APPLICATION

(21) Application number: 90124914.4

(51) Int. Cl.5: **G06F 15/60**

(22) Date of filing: 20.12.90

(30) Priority: 21.12.89 JP 329475/89

(43) Date of publication of application:
26.06.91 Bulletin 91/26

(84) Designated Contracting States:
CH DE FR GB LI NL SE

(71) Applicant: HITACHI, LTD.
6, Kanda Surugadai 4-chome
Chiyoda-ku, Tokyo 100(JP)

(72) Inventor: Tokumasu, Shinji
34-5, Nishinarusawacho-4-chome
Hitachi-shi(JP)
Inventor: Kawashima, Yasumasa
14-11, Okubocho-4-chome
Hitachi-shi(JP)
Inventor: Nonaka, Shiro
36-7-103, Nishinarusawacho-1-chome
Hitachi-shi(JP)
Inventor: Nakajima, Norihiro
28-1, Nishinarusawacho-1-chome
Hitachi-shi(JP)
Inventor: Kunitomo, Yoshio
28-22, Hanayamacho-2-chome
Hitachi-shi(JP)

(74) Representative: **Patentanwälte Beetz sen. -
Beetz jun. Timpe - Siegfried -
Schmitt-Fumian
Steinsdorfstrasse 10
W-8000 München 22(DE)**

(54) Method and apparatus for analyzing interference and apparatus for layout planning.

(57) A method and apparatus (160) is provided for analyzing interference caused between objects (220, 230, $G_1$ - $G_3$) when locating a plurality of objects ($G_1$ - $G_3$) in an n-dimensional space (210). The interference analyzing method takes the steps of dividing the n-dimensional space (210), approximating the object with a set of divided small areas, if the contour of the object is required to be approximated in more detail, dividing the small area into far smaller areas, approximating the object with a set of the far smaller areas, checking interference caused in the small area, if the interference is required to be checked more finely, iteratively doing the operation of dividing the small space into far smaller spaces and approximating the object with a set of the far smaller spaces, and if the interference is required to be roughly checked, organizing the far smaller spaces. Hence, the method and the apparatus (160) allows the rough interference analysis to be switched into the fine interference analysis or vice versa, thereby reducing the interference analysis data stored in memory.

FIG. 2

# METHOD AND APPARATUS FOR ANALYZING INTERFERENCE AND APPARATUS FOR LAYOUT PLANNING

## BACKGROUND OF THE INVENTION

The present invention relates to a method and an apparatus for analyzing how an object interferes with another object if these objects are designed to be placed in a restricted space. In particular, the invention relates to the method and apparatus for analyzing interference and an apparatus for layout planning which is capable of designing how the objects are located, the layout procedure as dynamically controlling analyzing accuracy of the interference from a low to a high level or vice versa.

In civil engineering or plant building, for example, it is necessary to plan proper arrangement of many instruments, pipelines and the like at premises having a restricted space so that those instruments, pipelines and the like do not occupy other part's spaces. And, the plan is further required to take account of several factors such as how the instruments and the pipes are to be installed, where working tables are to be installed, how the working benches are to be removed, and the like. If no account is taken into those factors when planning the arrangement, unfavorable situations may occur where the installed machine becomes an obstacle to new installation of another machine or a working bench, no installation of a working bench becomes disable to install the machine, or the installed machine makes it impossible to withdraw the working bench after finishing the relevant work. In designing a semiconductor integrated circuit such as a pattern layout or a print board, it is necessary to design arrangement of circuit elements and wiring so that no interference takes place among the circuit elements and wiring.

As will be understood from the above description, when designing a stationary plan about layout of objects or a dynamic plan about how and where to install objects, it is necessary to analyze and check how an object interferes with and effects on another for each object with an analyzing system. If no account is taken into this work, the actual installation of those objects may fail.

Some related arts relevant to layout planning and interference analyzing have been already proposed. For example, "Floor Planning System Using Tree Structure" disclosed in JP-A-63-308676 is designed for planning locations of circuit elements on a chip in building a large-scale integrated circuit. This system serves to represent how circuit elements are wired with tree structure and has a capability of processing the layout planning at high speed. An another example, "Method for Automatically Checking Interference between Objects" disclosed in JP-B-61-2229 can be referred. It can detect how an object interferes with another one from the located objects.

The former related art (JP-A-63-308676) can merely represent how objects are wired with tree structure so that the layout planning speed is made faster. It thus does not take any account into how a circuit element interferes with another circuit element for each element. This is because the layout planning is designed so that no interference occurs among the circuit elements. The latter related art (JP-B-61-2229) can merely check if interference occurs among the objects automatically. It takes no account into whether or not an operator can use the checking system with ease.

When an operator analyzes interference without using a computer, normally, the analyzing process takes the steps of roughly checking if interference occurs and finely checking the objects about which interference occurs. The related arts have not taken account into this process. They are designed to finely analyze interference from an initial stage. This method is disadvantageous in that it is against the normal process of designing a plan manually and it requires a vast amount of interference-analyzing data for fine analysis, thereby enlarging the memory capacity accordingly.

Moreover, the operation from the rough analysis to the fine analysis is changed according to each purpose of interference analysis, so that it may become complicated. It results in requiring the pre- and post-processing with large load. To avoid the processing, the interference analyzing apparatus has to be prepared independently of the apparatus to which it applies, for example, an apparatus for planning layout. The related arts have taken no account into this matter.

## SUMMARY OF THE INVENTION

It is therefore an object of the present invention to provide a method and an apparatus for analyzing interference which is capable of dynamically controlling the interference analysis from the rough analysis to the fine analysis or vice versa and thus reducing the interference analyzing data to be stored in memory.

In carrying out the object in a preferred mode, according to a first aspect of the invention, a method is provided for analyzing interference caused between objects when those objects are located in an n-dimensional space, the method comprising the steps of dividing the n-dimensional space, approximating the object with a set of divided small spaces, if a partial contour of the object is required to be approximated, dividing the small space into far smaller spaces, approximating the object with the far smaller spaces, for checking interference caused between the objects, checking the interference in the small space, if the interference is required to be more finely checked, repeating the operation of dividing the small space into far smaller spaces and approximating the object with a set of far smaller spaces, and if roughly checked, gathering the divided far smaller spaces.

According to a second aspect of the invention, an apparatus is provided for analyzing interference between objects when those objects are located in an n-dimensional space, the apparatus comprising a database storing the data about whether or not an object is crossed with a divided space of the n-dimensional space, the data represented with tree structure, and interference analyzing means for dividing the divided space into far smaller spaces if a plurality of objects are crossed with the divided space A, representing the data about whether or not the object is crossed with the more divided space B with the tree structure branched at a node matching to the divided space A and the branch matching to the more divided space B, being roughly represented, organizing the branches extended at the node and representing the data about whether or not the object is crossed with the divided space A at the node.

According to a third aspect of the invention, an apparatus is provided for analyzing how objects are located or designing a layout plan based on the information about how the objects are located in an n-dimensional space, the apparatus comprising:

a) means for defining the overall or partial space of the space with a set of small areas, the sum of small areas covering the overall or partial space and allowing them to be overlapped;

b) at least one of means for dividing one small area included in the set of small areas defining the overall space into far smaller areas, the far smaller areas covering the small area, and means for organizing some of far smaller areas and reconstructing one small area,

c) means for matching an object crossed with the small area to each small area defining the layout space as following or interlocking a) and b) means, approximating the small area itself as a part of the object for generating and reconstituting the object layout information, and

d) means for retrieving the object layout information on a unit of the small area, means for dynamically dividing the small area or reconstructing the small areas with the means of b).

According to a fourth aspect of the invention, a layout planning apparatus is provided for reading a size and form of an object, and layout rules and locating the objects in a restricted space in accordance with the layout rules, the layout planning apparatus serving to analyze how an object interferes with another object and define where to locate the objects for avoiding the interference caused among the objects.

In operation, the object layout information for analyzing the layout of objects is stored in memory. The information stored in the memory is changed into the latest state based on the necessary representation accuracy as the object is registered (added), changed and deleted in the space during the layout planning time. Moreover, the information may go back to that based on the previous representation accuracy. In response to an inquiry outside of an interference analyzing apparatus, for example, from a layout planning apparatus, the required interference analyzing results is returned from the object layout information stored in the memory. It means that the checking results about scrambling for a space between objects, interference between objects, unoccupied space and the like are returned in such a format as being usable by the inquirer.

The present invention is designed to uniquely manage the object layout information in an n-dimensional space based on a predetermined data structure. Hence, it can restrict the portion of the object for finely analyzing the interference and reconstitute the details about the portion on which no inteference takes place, thereby saving the memory capacity.

According to the invention, the interference analyzing apparatus is a closed machine. Naturally, it is independently of another apparatus to which the interference analyzing apparatus applies such as the layout planning apparatus.

Further objects and advantages of the present invention will be apparent from the following description of the preferred embodiments of the invention as illustrated in the accompanying drawings.

BRIEF DESCRIPTION OF THE DRAWINGS

Fig. 1 is a block diagram showing a layout planning apparatus providing an interference analyzing apparatus accoridng to an embodiment of the invention;

Fig. 2 is a view describing a definition environment of a database used in an interference analyzing method according to an embodiment of the invention;

Figs. 3a, 3b and 3c are views for illustrating how object data is registered in the database;

Figs. 4 and 5 are charts illustrating how object data is added to the database;

Fig. 6 is a chart illustrating how object data is deleted from the database;

Fig. 7 is a chart illustrating how the database is worked; and

Fig. 8 is a view illustrating the analysis of an installing route to which the interference analyzing apparatus designed according to the embodiment of the invention is applied.

DESCRIPTION OF THE PREFERRED EMBODIMENTS

Hereinafter, an embodiment of the invention will be described with reference to the drawings.

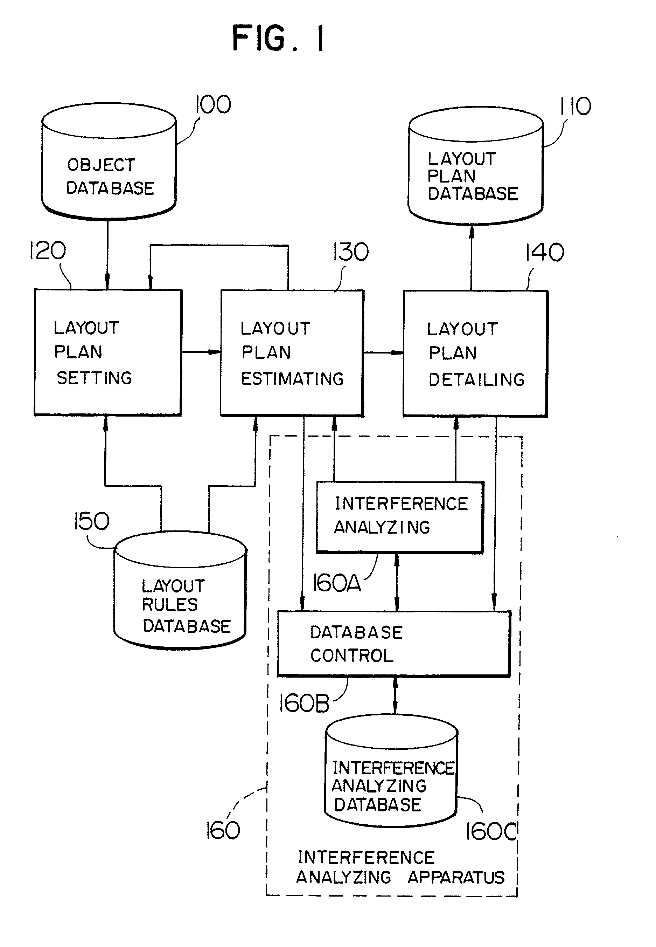

Fig. 1 is a block diagram showing a layout planning apparatus providing an interference analyzing apparatus according to an embodiment of the invention. The layout planning apparatus comprises an object database 100 storing data of various objects to be located, a layout rules database 150 saving data about layout rules of objects when designing the plan, a layout plan setting means 120 for mainly designing a stationary layout plan based on the layout object data, the layout rules data and the layout plan estimated value, a layout plan setting means 120 for estimating the plan from the stationary layout plan and the layout rules and feeding back the estimated value to the layout plan setting means 120 if necessary, a layout plan detailing means 140 for designing a final dynamic layout plan from the stationary layout plan, a layout plan database 110 for storing the detailed layout plan, and an interference analyzing apparatus 160, the last element of which is specific to this embodiment.

The interference analyzing apparatus 160 receives the stationary layout plan from the layout plan estimating means 130 and the dynamic layout plan from the layout plan detailing means 140 and performs the interference analysis. The analyzed result is sent to the layout plan estimating means 130 or the layout plan detailing means 140 for making the estimating or detailing accuracy higher. The interference analyzing apparatus 160 provides an interference analyzing means 160A for performing interference analysis and outputting the analyzed result, an interference analysis database 160C for storing the interference analysis data (to be detailed later), and a database control means 160B for reading the stationary layout plan or the dynamic layout plan and reading the necessary interference analyzing data from the database 160C and passing the data to the interference analyzing means 160A.

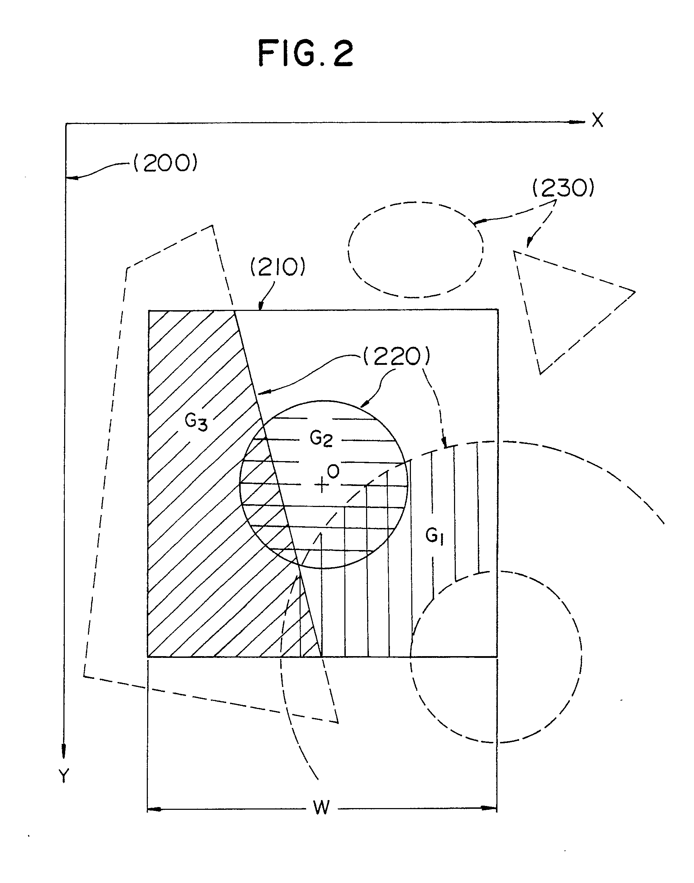

Fig. 2 is a view illustrating how interference is analyzed according to an embodiment of the invention. The present invention concerns with analysis of interference caused among objects in an n-dimensional restricted space. The number of n is not limited, but herein, the embodiment is described on n = 2, that is, planar space. In addition, if n = 3, the interference analysis can be done in cubic space. If n = 4, that is, the cubic space plus time axis, it is possible to analyze the interference of moving objects in a local space, that is, whether or not a moving object collide with another one. If n takes a larger number, it is also possible to analyze interference of objects in abstract space.

In Fig. 2, the layout space 210 (also referred to as basic area) is defined on a reference coordinate system 200. The interference analyzing database 160C contains the interference analysis data defined in a partial space 210 restricted by a layout space 210 (n-dimensional space with W side-length, herein, square space with W side-length). In an illustrative example, there are provided an object 220 being overlapped on the partial space 210 and an object 230 being separated from the partial space 210. The subject object is the object 220, which includes an object G2 completely contained in the space 210 and objects G1, G3 partially overlapped with the space 210.

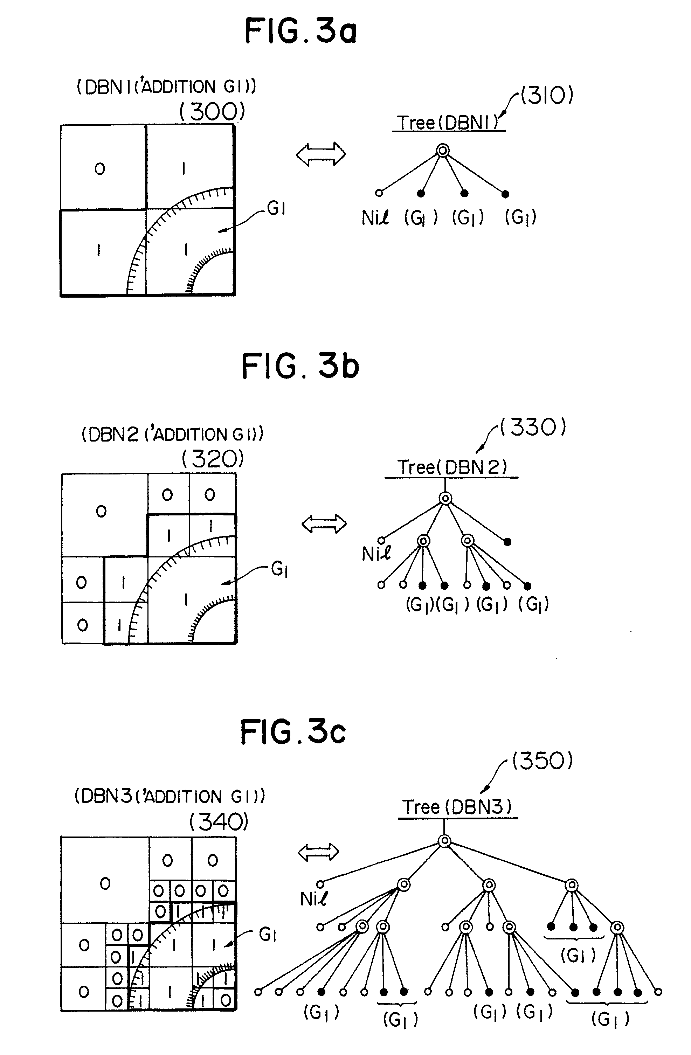

To analyze how those objects G1, G2, G3 interfere with one another, at first, it is necessary to know where the objects G1, G2, G3 are respectively located. For the purpose, the layout space 210 is divided into four areas as shown in the left part of Fig. 3a. In the layout space 210, the divided area crossed with the object G1 is denoted by "1" and the divided area not being crossed with it is denoted by "0". It means that the object G1 does not exist in an area of "0" and exists in an area of "1". For more finely grasping the layout of the objects, the divided area of "1" is divided into four areas. (the divided area of "0" is not further divided, because it does not provide the object G1) The divided area in which the object G1 exists is denoted by "1" and the divided area in which the object G1 does not exist is denoted by "0". For more finely checking the layout, the divided area "1" at the border of the object G1 is divided into four areas. It results in obtaining a map shown in the left part of Fig. 3c. The right parts of Figs. 3a, 3b and 3c illustrate tree structures respectively representing the maps shown in the left parts of Figs. 3a, 3b and 3c. A branch having a black dot at the tip denotes "1" and a branch having a circle at the tip denotes "0". Based on the tree structure of each object, the interference analysis data can be created. To handle the interference analyzing apparatus with ease, the data format (to be described later) is employed. The present embodiment employs four-branched tree structure for the structure of the interference analyzing data, but $2^n$-branched tree structure.

Then, the description will be directed to a reference format, that is, a descriptive format of data for starting up means for executing from the outside a defining method, a deleting method, a using method and a working method of the interference analysis data under the foregoing definition environment and the processed content matching to the reference format. The processed content is described only if it can be obviously realized. The term "database (DB)" used hereinafter means the interference analysis database 160C or each data unit composing the database 160C.

(1) Definition of Database

Reference Format: (DB definition, Database Name DBN, Basic Area (Center O, Side Length W), Depth of Four-branched Tree N)

Processed Content:
(i) The step of taking the inside of the square area with the center O and one side length W as a basic area on which the interference analysis database (DBN) is regulated against the reference coordinate system set as a coordinate system regulating the layout space. Then, only the object included in or crossed with the basic area is managed (or controlled).
(ii) The step of representing the object to be managed on the basic area by a four-branched tree structure. The accuracy is represented by how deeply the four-branched tree N extends (the depth of the basic area itself is N = 0).
(iii) The step of initializing as Nil a four-branched tree structure Tree (DBN) storing the data representing the object to be located.

With the foregoing function of "DB definition", a lot of databases intended for the purpose may be created as required.

(2) Deletion of Database

Reference Format: (DB deletion, Database Name DBN)
Processed Content: Deleting the database itself titled as DBN and all the data stored in the database. (3) use of Database (Accumualtion, Retrieval)

Reference Format:
a) (DBN)
b) (DBN ('addition object name G))
c) (DBN ('deletion object name G))
Processed Content: For the reference format of a), the Tree of the database titled as DBN takes a functional value.

For the reference format of b), the object G is represented by a four-branched tree and is added to the database (DBN). If the object G has already existed in the Tree (DBN) of the database, nothing is done. It means the reference format b) has the same effect as the reference format a). If not, the object G is represented by the four-branched tree until it reaches the depth N. If the represented result is not Nil, the object G is combined with Tree (DBN) so that Tree may be updated and is given back as a functional value.

For the reference format of c), the quite reverse operation to the reference format of b) is required. That is, the data of the object G is deleted out of the database titled as DBN. If no data of the object G exists in Tree (DBN), nothing is done. It means the reference format c) has the same effect as the reference format a). If the data of the object G exists in Tree, the data of the object G is deleted from the database as if no "addition" is done by the reference format b). Tree (DBN) is given back as a function value.

Then, the description will be directed to the structure of Tree (DBN) and the generating process of "addition" and "deletion" of the reference formats b) and c) with reference to Figs. 3a, 3b and 3c to 6.

Figs. 3a, 3b and 3c are views showing how the database is changed when the object G1 (reference format (DBNi('addition G1))) (where i = 1, 2, 3) is registered in the initialized database. Figs. 3a, 3b and 3c respectively show Trees (DBi) of the databases DBN1, DBN2 and DBN3 with respective depths N of "1", "2" and "3".

If N = 1 as shown in Fig. 3a, the object G1 is approximated to a divided area (cell with a depth of N-1 on the data structure map 300 transcribed on the basic area. At this time, the corresponding database is represented like the tree structure 310 and structured to have at the tip node an object name (G1) crossed with the cell.

Further, it is possible to obtain a data structure 330 matching to the data structure map 320 shown in Fig. 3b and a data structure 350 matching to the data structure map 340 shown in Fig. 3c by the respective lengths are set as N = 2 and N = 3. That is, by increasing or decreasing the depth N, the accuracy of approximation with the cell of the object G can be controlled.

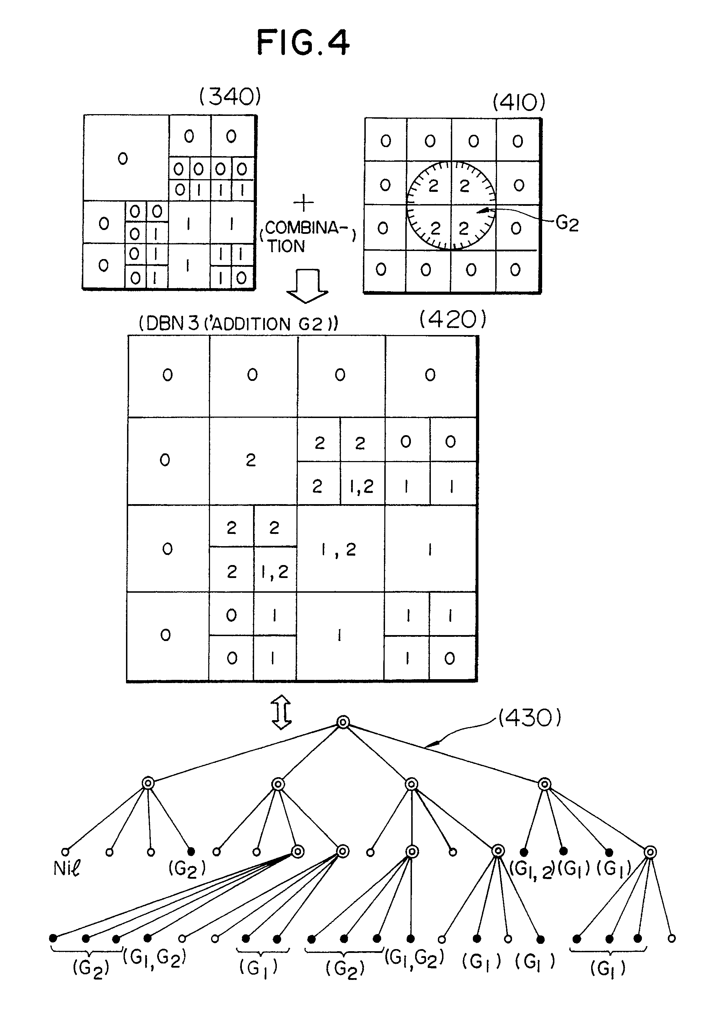

As mentioned above, as the database of the object G1, it is possible to create any data structure Tree (DBNi) for the depth N = 1, N = 2 and N = 3 and save the creating result in the interference analyzing database 160c shown in Fig. 1. Then, the description will be directed to the function of adding the data of the object G2 to the database of the object G1 with reference to Fig. 4. The data depth of the object G1 is assumed as N = 3 and the data depth of the object G2 is assumed as N = 2.

The database for the object G1 is termed as DBN3 to which the data of the object G2 is added. The reference format is (DBN3('addition G2)).

When added, a data structure map 410 of the object G2 is combined with the data structure map 340, resulting in forming a data structure map 420. The tree-structured data structure matching to the map 420 is denoted by 430.

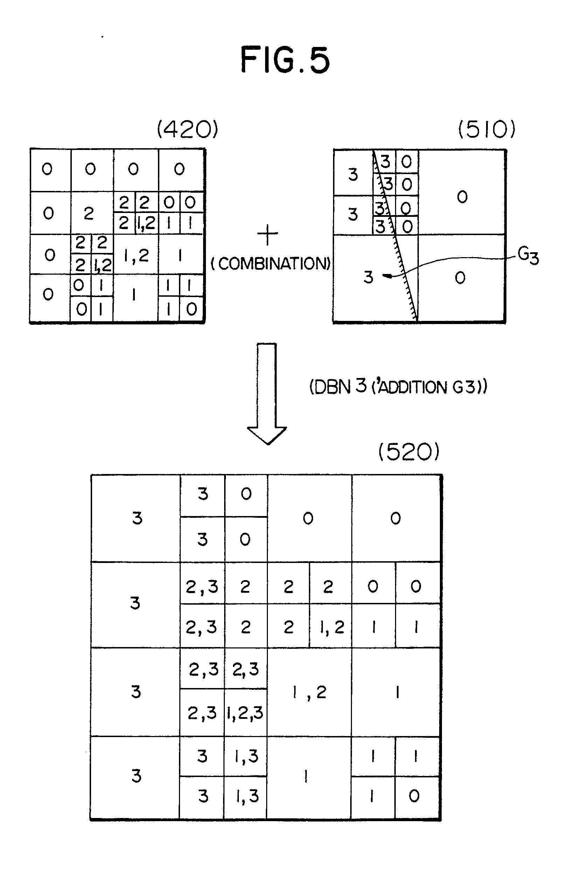

Fig. 5 shows the result of combining the data of the object G3 with the database combining the object G1 with the object G2 described in Fig. 4. The reference format is (DBN3('addition G3)). The combination of the map 420 to the map 510 of the object G3 (depth N = 3) results in forming a map 520.

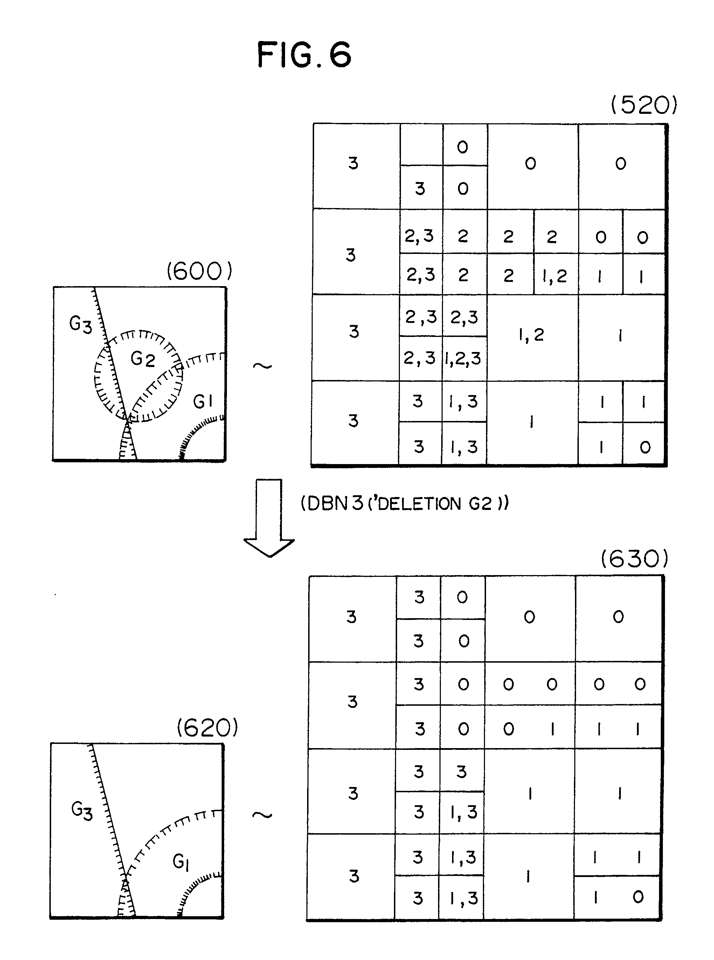

Fig. 6 is a view for describing a function of deleting the data of the object G2 from the database having the objects G1, G2 and G3 combined therein. The reference format of the deletion is (DBN3('deletion G2)). With the reference format, a basic area 600 of the database and a data structure map 520 matching to it are respectively changed to a basic area 620 and a map 630.

(4) Working of Database

The database structure, an entity of data included in one database, is a result of recursively dividing the basic area in a four-branched-tree manner. The branches extending after any middle node may be assumed as a partial database having the cells matching to the nodes as new basic areas. That is, the database itself functions recursively. With respect to the tip node of Tree ( ), the object name is assumed as an attribute value. Hence, with the increase of the depth N of the node from which the partial database is started, the accuracy of approxiamting the object is made higher and localized. Similarly, the created database can change the data structure by changing the depth N of the node.

As a result of considering the foregoing points, it is necessary to perform at least the following operations about the working of the database.

Reference Format:
  a) (DBN('depth depth N))
  b) (DBN('accuracy increase or decrease of depth ±n))
  c) (DBN('transcribe new database DNT))
  d) (DBN('piece element number i of top level of Tree(DBN))
  where i = 0, 1, 2, 3
  e) (DBN('combination existing database DBNF))
Processed Content:

All the reference formats except the reference format b) commonly provide the resulting Tree (DBN) as a function value.

For the reference format a), the original data structure Tree (DBN) is worked so that the depth of the database DBN reaches a specified depth N. Once it reaches the specified depth N, the database DBN keeps the specified depth N.

For the reference format b), it has a substantially analogous function to the format a). The database keeps its name unchanged. The database is worked to have a four-branched-tree data increased or decreased by ±n, that is, a value by which the depth N of the current Tree (DBN) is specified. The worked result becomes a value of function.

For the reference format c), it produces as DBNT the database which is equivalent to the database named as DBN. It means that this process is for copying the database.

For the reference format d), it is for localizing a partial database. That is, the localizing process means that the new data structure is used as the i-th partial tree selected among the four partial trees starting at a node of the depth N-1, that is, the partial tree at the top level of the database Tree (DBN) named as DBN. In this case, the depth N is decreased by 1.

For the reference format e), it processes to combine the database DBN with another database DBNF on the consumption that both have the same basic area and provide the combinating result as a database named as DBN. The database DBN is left unchanged. If both databases have respective depths, the depth of the database DBN is selected.

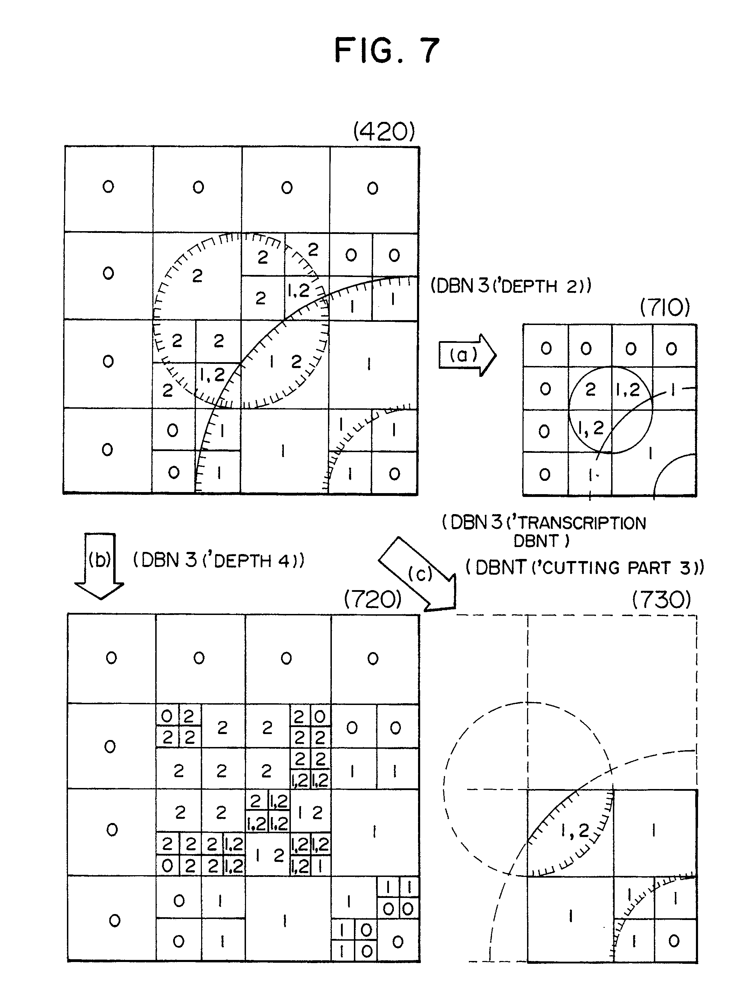

Fig. 7 illustrates how to work the database. The arrow (a) indicates the process of decreasing the depth of the original database by 1, that is, using the format of;
(DBN3 ('depth 2))
The arrow (b) indicates the process of increasing the depth of the original database by 1, that is, using the format of;
(DBN3 ('depth 4))
The arrow (c) indicates the process of saving DBN3 with the format of;
(DBN3 ('transcribe DBNT))
defining the database DBNT as a partial database organized by partial trees starting at the third top-level node of the database DBN3 with the format of;
(DBNT ('cutting part 3))
Those operations result in changing the data structure map 420 of the database into maps 710, 720, 730.

The process indicated by the arrow (c) of Fig. 7 further includes the format of (DBNT ('cutting part 0)), resulting in obtaining a more localized database. Herein, with the format of DBNT ('depth 3)), the representing level of the contour of this portion is graded up two ranks.

As mentioned above, the data of an object located in a restricted space is represented with a

$2^n$-branched tree structure. By changing the depth N, as freely moving the rough structure to the fine structure or vice versa, the data is allowed to be worked and a plurality of pieces of data can be freely combined or deleted. It results in allowing a degree of interference caused among objects to be analyzed at any accuracy from rough to fine level. Provision of a next function as means for analyzing interference results in improving ease of use. In the four-branched tree data structure, the interference analyzing means uses the list of objects crossed with cells matching to the nodes as the attributes of the tip nodes included in the four-branched tree. It provides at least the following functions:

(a) Listing the objects occupying a given area and calculating some factors such as an occupation ratio,

(b) Detecting interference caused among the objects and analyzing what kind of form of the interference, and

(c) Specifying an empty area in which the objects are not occupied and analyzing what kind of form of the area.

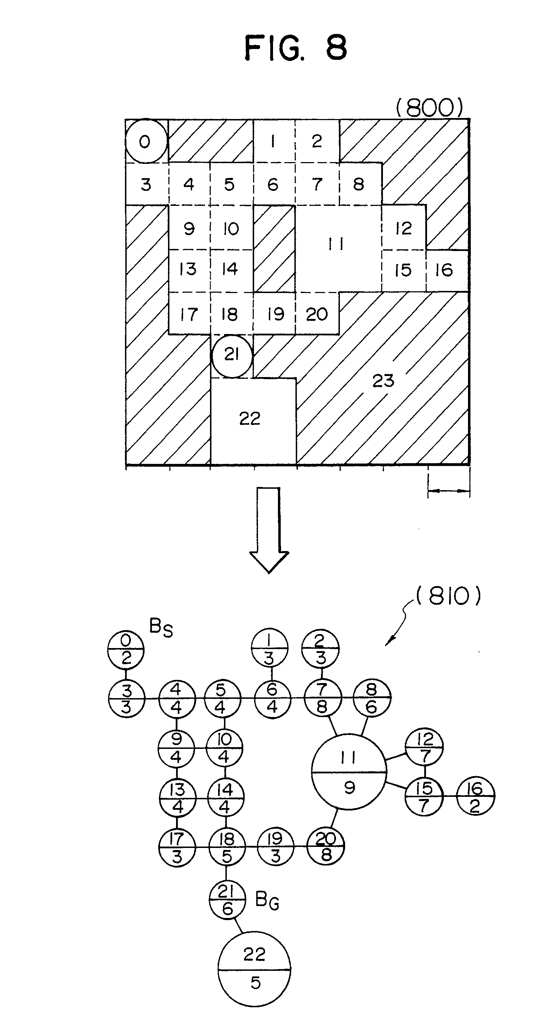

Turning to Fig. 8, upgraded interference analysis will be described. The embodiment shown in Fig. 8 is for searching an installing route of an object to be installed to the layout space. In this case, by estimating each space area as mentioned below, the installing route may be defined.

The layout space map 800 of Fig. 8 is created by the functions (a) to (c). 0 to 22 denote empty cells. A cell collection 23 with an oblique line is an area which the existing object occupies. To know what occupying degree of the occupied cell in detail, it is necessary to change the depth of data about an occupying object and to check what level of occupying degree in the branched tree structure, resulting in allowing the empty cell to be used for installation to be finely checked. This embodiment is designed to obtain the installing route assumed that an object is entered at a cell numbered as 0 and is installed at a cell 21. The cell 0 denotes a starting cell BS and the cell 2I denotes a finishing point cell BG.

When an object is installed, it is natural that the size of the object restricts the installing route. Hence, the installing route to the final cell BG is restricted. If there exist a plurality of installing routes, the optimal installing route is selected in light of the installing work and the working cost. Concretely, for defining an optimal route, it is determined whether or not the peripheral space of the route is wide enough to install the object, whether the length of the route is short and whether or not the number of curves provided in the route is small.

A graph 810 shown in Fig. 8 shows an allowable area created by the map 800 for defining the optimal installing route in light of the foregoing factors. In the graph 810, each circle matching to each node indicates an empty cell. The graph is created by connecting the adjacent cells (circles). The value shown at the upper stage of each circle indicates a cell number and the value shown at the lower stage of each circle indicates the degree of use of cells based on whether or not the peripheral space is long and wide enough to install the object and whether or not the number of curves is small as mentioned above. The graph 810 can be created by scanning the data structure of the interference analysis database. To search the optimal route in light of the graph 810, the searching can be achieved by an A*algorithm used in a method for artificial intelligence.

The foregoing interference analysis apparatus may be solely used. With the large load applied therein, however, it is possible to provide a plurality of interference analyzing apparatuses, perform the process in parallel by dispersing the load and improve the processing speed.

As described above, the present embodiment employs $2^n$-branched tree as data structure and constitutes the interference analyzing database for storing the basic data on which how the layout spaces are provided is analyzed. Further, the embodiment provides means for organizing a series of operations of the database such as definition, deletion, use and work by referencing these operations from the outside. It provides means for carrying out interference analysis in the database as means for organizing the operations. The embodiment thus provides a general-purpose interference analyzing apparatus for general layout planning which allows an object with any form to be located in any layout space.

The layout planning apparatus to which the interference analyzing apparatus according to the embodiment is applied provides an interference analyzing apparatus independently of the apparatus itself. Hence, it can easily keep and expand the system.

According to the invention, the interference analysis which is common to and necessary to the layout plan can be processed independently of the other parts. Further, it can select the layout space and object with any form. In the structure of the contained data, the form may be changed in a manner to match any expression from the rough expression to the detailed one or vice versa together with the dynamic change of the representation accuracy. It results in allowing the general-purpose interference analysis to be realized and the location planning apparatus with expansion of the system to be built:

The following is also other independent features of the present invention.

(1) An interference analyzing apparatus (160) for analyzing or planning how objects are located based on object location information in an n-dimensional layout space, comprising:

i) means (160C) for keeping object layout information at a predetermined data structure;

ii) means (160B) for directly accessing said means i) and creating, editing and retrieving object layout information containing registration and deletion of objects; and

iii) means (160A) for indirectly effecting on said means i) through said means ii) through said means ii).

(2) An interference analyzing apparatus (160) in item (1), wherein and ii) and iii) means (160B, 160A) composes one mechanism in a manner that said ii) means (160B) is subordinate to said iii) means (160A).

(3) An interference analyzing apparatus (160) for processing a design of an object based on object layout information in an n-dimensional layout space, said apparatus (160) comprising:

i) means (160C) for keeping said object layout information at a predetermined data structure; and

ii) means (160B) for directly accessing said means i) and creating, editing and retrieving object layout information containing registration and deletion of objects.

(4) The interference analyzing apparatus (160) in any one of items (1) to (3), further comprising means for recursively doing the divisional operation of setting an area covering the overall or partial layout space as a window, dividing said window into a plurality of small windows, and dividing said small window into a plurality of far smaller windows, assuming a collection of smaller windows as a collection of small areas regulating said layout space, creating the object layout information in a manner to match each smaller window to the object as being interlocked with said divisional operation, and overall and locally reconstructing said object layout information by setting the windows and giving the repetitive number of divisional operations and reverse generalizing operations.

(5) An interference analyzing apparatus (160) comprising a plurality of interference analyzing units, each unit being designed to disperse load when processing said load.

(6) The interference analyzing apparatus (160) in item (5), wherein an individual interference analyzing apparatus for doing processing in a dispersing manner using the interference analyzing apparatus described in items 2 or 5 and 1 to 4.

(7) The interference analyzing apparatus (160) in item (5) or (6), wherein the load is dispersed in light of a type of an object, an occupying area of an object, and crowdedness of a layout object.

(8) A layout planning apparatus (120, 130, 140) for reading sizes of objects, form data, and layout rules in a restricted layout space in accordance with said layout rules, comprising the interference analyzing apparatus described in any one of the items 1 to 7 for analyzing the interference between objects and defining layout which does not cause interference when actually locating the object in said layout space.

**Claims**

1. An interference analyzing method for analyzing interference among objects (220, 230, $G_1$ - $G_3$) when locating a plurality of objects (220, 230, $G_1$ - $G_3$) in an n-dimensional space (210), said method comprising the steps of dividing said n-dimensional space (210), approximating said object ($G_1$) with a set of said divided small spaces (300, 310), if the contour of said object (G1) is required to be approximated in more detail, dividing said smaller spaces, approximating said object (G1) with a set of said smaller spaces (320, 330), checking interference caused in said small space (300, 310), if the interference is required to be checked in more detail, repeating the operation of dividing said smaller space (320, 330) and approximating said object (G1) with a set of far smaller space (340, 350), and if the interference is required to be roughly checked, organizing said far smaller spaces (340, 350).

2. An interference analyzing apparatus (160) for analyzing interference caused between objects (220, 230, G1 - $G_3$) in an n-dimensional space (210), said apparatus comprising a database (160C) for storing data about whether said object is crossed with the divided spaces of said n-dimensional space (210), said data structured in a tree-structure manner, and means (160A) for analyzing interference, said means (160A) serving to divide said divided space in far smaller spaces B when a plurality of objects are crossed with a divided space A, more finely representing data about whether or not said smaller spaces B are crossed with said objects (220, 230, $G_1$ - $G_3$) by extending branches matching to said smaller spaces B at a node matching to said divided space A, organizing said branches extending at said node, and representing data about whether or not said node is crossed with said object.

3. A layout planning apparatus (120, 130, 140) for reading data (100) about a size and form of an object and layout rules (150) and locating said object in a restricted layout space (210) in accordance with said layout rules (150) comprising the interference analyzing apparatus (160) described in claim 2 for analyzing interference caused between said objects (220, 230, $G_1$ - $G_3$) and defining the layout which does not bring about the interference between said objects (220, 230, $G_1$ - $G_3$) when actually locating said object in said layout space (210).

4.  A layout planning apparatus for reading data (100) about a size and form of an object and layout rules (150) and locating said object in a restricted layout space (210) in accordance with said layout rules (150), comprising the interference analyzing apparatus described in claim 2 for estimating an empty area between the objects (220, 230, $G_1$ - $G_3$), analyzing said empty area, and defining an installing route along which said object is installed.

5.  An interference analyzing apparatus (160) for analyzing and planning how an object is located in an n-dimensional layout space (210) based on object layout information, said interference analyzing apparatus (160) comprising:
    at least one of a) means (160A) for defining the overall or partial layout space with a set of a plurality of small areas, the sum of said small areas covering the overall or partial layout space and allowing said areas to be overlapped with one another and b) means (160A) for dividing one of said small areas into a plurality of far smaller area and organizing some of said far smaller areas into one small area,
       c) means (160C) for creating and reconstituting said object layout information by matching the object crossed with said small area to said each small area defining said layout space and approximating a part of said object with said small area as following or being interlocked with said a) and b) means, and
       d) means (160B) for retrieving said object layout information with a unit of said small area and dynamically dividing said small area for more fine representation or organizing said small areas for more general representation.

6.  The interference analyzing apparatus (160) as claimed in claim 5, where said small areas are analogous to each other.

7.  The interference analyzing apparatus (160) as claimed in claim 5, wherein the data containing the object layout information takes a tree structure and the tree-structured data is created, reconstructed and retrieved.

8.  A layout planning apparatus (120, 130, 140) for reading data (100) about a size and form of an object and layout rules (150) and locating said object in a restricted layout space (210) in accordance with said layout rules (150) comprising the interference analyzing apparatus (160) described in claim 5 for analyzing interference caused between said objects (220, 230, $G_1$ - $G_3$) and defining the layout which does not bring about the interference between said objects (220, 230, $G_1$ - $G_3$) when actually locating said object in said layout space (210).

# FIG. 1

# FIG. 2

# FIG. 3a

(DBN1('ADDITION G1))
(300)

(310)
Tree(DBN1)

# FIG. 3b

(DBN2('ADDITION G1))
(320)

(330)
Tree(DBN2)

# FIG. 3c

(DBN3('ADDITION G1))
(340)

(350)
Tree(DBN3)

# FIG.4

(340)

(410)

+
(COMBINA-)
TION

G2

(DBN 3 ('ADDITION G2))　(420)

(430)

Niℓ　(G2)

(G₂)　(G₁,G₂)　(G₁)　(G₂)　(G₁,G₂)　(G₁)　(G₁)　(G₁)

(G₁,2)(G₁)(G₁)

# FIG.5

(420)

(510)

+ (COMBINATION)

G3

(DBN 3 (ADDITION G3))

(520)

# FIG. 6

(520)

(600)

(DBN 3 ('DELETION G2))

(630)

(620)

15

# FIG. 7

(420)

(DBN 3 ('DEPTH 2))

(a)

(710)

(DBN 3 ('TRANSCRIPTION DBNT)

(b) (DBN 3 ('DEPTH 4))

(c) (DBN 3 ('TRANSCRIPTION DBNT)

(DBNT ('CUTTING PART 3))

(720)

(730)

# FIG. 8

(800)

(810)